# EUROPEAN PATENT APPLICATION

(11) **EP 2 642 514 A1**
(43) Date of publication of application: **25.09.2013**
(21) Application number: 11842262.5
(22) Date of filing: 14.07.2011
(51) Int. Cl.: H01L 21/337, H01L 21/205, H01L 29/808

(54) **SILICON CARBIDE SEMICONDUCTOR DEVICE**

(30) Priority: 16.11.2010 JP 2010255940
(71) Applicant: Sumitomo Electric Industries, Ltd., Osaka-shi, Osaka 541-0041 (JP)
(72) Inventor: FUJIKAWA, Kazuhiro, Osaka-shi Osaka 554-0024 (JP)
(74) Representative: Grünecker, Kinkeldey, Stockmair & Schwanhäusser
(86) International application number: PCT/JP2011/066094
(87) International publication number: WO 2012/066820

(57) **Abstract**

A silicon carbide semiconductor device is provided which has a lower on-resistance and a higher breakdown voltage than those of a conventional silicon carbide semiconductor device. A JFET (10) according to the present invention includes an n type substrate (11), a p type layer (2, 12), an n type layer (13), a source region (15), a drain region (17), and a gate region (16). The n type substrate (11) has a main surface (11A) having an off angle of not less than 32° relative to the {0001} plane, and is made of silicon carbide (SiC). The p type layer (2, 12) is formed on the main surface (11A) of the n type substrate (11), and has p type conductivity. The n type layer (13) is formed on the p type layer (2, 12), and has n type conductivity. The source region (15) and the drain region (17) are formed in n type layer (13) with a space interposed therebetween, and have n type conductivity. The gate region (16) is formed in the n type layer (13) at a region between the source region (15) and the drain region (17), and has p type conductivity.

## Description

### TECHNICAL FIELD

The present invention relates to a silicon carbide semiconductor device, more particularly, a silicon carbide semiconductor device serving as a lateral type junction field effect transistor.

### BACKGROUND ART

Conventionally, a lateral type junction field effect transistor has been known as a silicon carbide semiconductor device (for example, see Japanese Patent Laying-Open No. 2003-68762 (Patent Literature 1)). In such a lateral type junction field effect transistor, a current in a channel layer and an electric field in a drift layer are in a lateral direction. When forming such a lateral type junction field effect transistor on a substrate made of silicon carbide (SiC), it is general to use, as the substrate, a substrate made of 4H-SiC and having a main surface having a plane orientation corresponding to a {0001} plane. In the above-described silicon carbide semiconductor device, the current in the channel layer and the electric field in the drift layer are in a direction parallel to the main surface of the substrate (i.e., direction parallel to the {0001} plane (such as a [11-20] direction).

### CITATION LIST

### PATENT LITERATURE

PTL 1: Japanese Patent Laying-Open No. 2003-68762

### SUMMARY OF INVENTION

### TECHNICAL PROBLEM

In the conventional silicon carbide semiconductor device described above, the current in the channel layer flows in the direction parallel to the {0001} plane. Accordingly, mobility of electrons in the channel layer is lower than that in a case where a current flows in other directions. Specifically, the mobility of electrons in the direction parallel to the {0001} plane (such as the [11-20] direction) is approximately 0.8 times as large as the mobility of electrons in a direction perpendicular to the {0001} plane. Hence, the above-described conventional silicon carbide semiconductor device exhibits an on-resistance higher than a theoretical value of on-resistance supposed to be attained when general silicon carbide is utilized.

Further, in the drift layer of the above-described conventional silicon carbide semiconductor device, an electric field is applied in the direction parallel to the {0001} plane. The dielectric breakdown electric field of silicon carbide in the direction parallel to the {0001} plane is approximately 0.75 times as large as that in the direction perpendicular to the {0001} plane. Accordingly, the above-described conventional silicon carbide semiconductor device exhibits a breakdown voltage lower than a theoretical value of breakdown voltage supposed to be attained when general silicon carbide is utilized. Thus, it cannot be said that the conventional silicon carbide semiconductor device sufficiently exhibits the properties of silicon carbide.

The present invention has been made to solve the foregoing problems, and has its object to provide a silicon carbide semiconductor device having a lower on-resistance and a higher breakdown voltage than those in the conventional silicon carbide semiconductor device.

### SOLUTION TO PROBLEM

A silicon carbide semiconductor device according to the present invention includes a substrate, a first semiconductor layer, a second semiconductor layer, a source region, a drain region, and a gate region. The substrate has a main surface having an off angle of not less than 32° relative to a {0001} plane, and is made of silicon carbide. The first semiconductor layer is formed on the main surface of the substrate, and has a first conductivity type. The second semiconductor layer is formed on the first semiconductor layer, and has a second conductivity type. The source region and the drain region are formed in the second semiconductor layer with a space interposed therebetween, and have the second conductivity type. The gate region is formed in the second semiconductor layer at a region between the source region and the drain region, and has the first conductivity type.

In this way, the silicon carbide semiconductor device according to the present invention is configured as a lateral type junction field effect transistor and has a drift layer in which an electric field is applied in a direction parallel to the main surface of the substrate (i.e., direction along the surface having an off angle of not less than 32° relative to the {0001} plane). Accordingly, the breakdown voltage can be increased by 10% or greater as compared with that of the conventional silicon carbide semiconductor device in which the electric field is applied in the direction parallel to the {0001} plane. Further, according to the present invention, a current in the channel layer of the silicon carbide semiconductor device flows in the direction parallel to the main surface of the substrate, which has an off angle of not less than 32° relative to the {0001} plane. Accordingly, the mobility of electrons can be increased in the channel layer as compared with that in the conventional silicon carbide semiconductor device (that in the case where a current in the channel layer flows in the direction parallel to the {0001} plane). Accordingly, on-resistance can be reduced as compared with that in the conventional silicon carbide semiconductor device.

### ADVANTAGEOUS EFFECTS OF INVENTION

The present invention provides a silicon carbide semiconductor device having a lower on-resistance and a higher breakdown voltage than those in the conventional silicon carbide semiconductor device, by employing a substrate having a main surface corresponding to a crystal plane having a large off angle relative to a {0001} plane.

### BRIEF DESCRIPTION OF DRAWINGS

Fig. 1 is a schematic cross sectional view showing a first embodiment of a silicon carbide semiconductor device according to the present invention.
Fig. 2 is a flowchart for illustrating a method for manufacturing the silicon carbide semiconductor device shown in Fig. 1.
Fig. 3 is a schematic cross sectional view for illustrating the method for manufacturing the silicon carbide semiconductor device shown in Fig. 1.
Fig. 4 is a schematic cross sectional view for illustrating the method for manufacturing the silicon carbide semiconductor device shown in Fig. 1.
Fig. 5 is a schematic cross sectional view for illustrating the method for manufacturing the silicon carbide semiconductor device shown in Fig. 1.
Fig. 6 is a schematic cross sectional view for illustrating the method for manufacturing the silicon carbide semiconductor device shown in Fig. 1.
Fig. 7 is a schematic cross sectional view for illustrating the method for manufacturing the silicon carbide semiconductor device shown in Fig. 1.
Fig. 8 is a schematic cross sectional view for illustrating the method for manufacturing the silicon carbide semiconductor device shown in Fig. 1.
Fig. 9 is a schematic cross sectional view for illustrating the method for manufacturing the silicon carbide semiconductor device shown in Fig. 1.
Fig. 10 is a schematic cross sectional view for illustrating the method for manufacturing the silicon carbide semiconductor device shown in Fig. 1.
Fig. 11 is a schematic cross sectional view showing a second embodiment of the silicon carbide semiconductor device according to the present invention.
Fig. 12 is a graph showing a relation between inclination of the crystal plane of the main surface of the substrate of the silicon carbide semiconductor device relative to the {0001} plane and each of breakdown electric field strength in a drift portion thereof and mobility of electrons in a channel thereof.

### DESCRIPTION OF EMBODIMENTS

The following describes embodiments of the present invention with reference to figures. It should be noted that in the below-mentioned figures, the same or corresponding portions are given the same reference characters and are not described repeatedly.

### (First Embodiment)

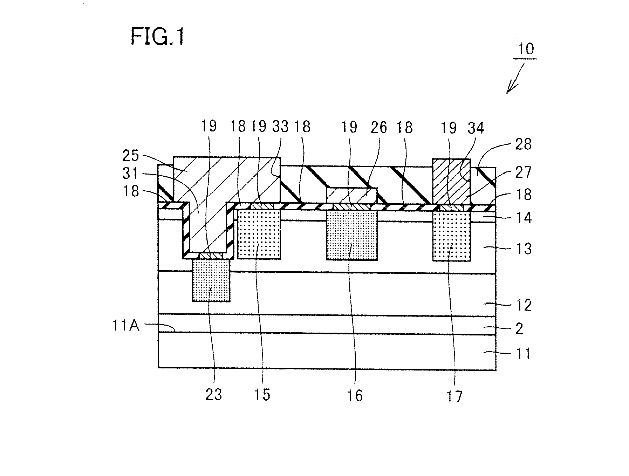

Referring to Fig. 1, a first embodiment of a silicon carbide semiconductor device according to the present invention will be described below. The silicon carbide semiconductor device shown in Fig. 1 is a JFET (Junction Field Effect Transistor). JFET 10 shown in Fig. 1 includes: an n type substrate 11 made of silicon carbide (SiC) and having n type conductivity; a p type layer 2 formed on n type substrate 11 and serving as an electric field relaxing layer; a p type layer 12 formed on p type layer 2 and serving as a breakdown voltage holding layer; an n type layer 13 formed on p type layer 12; and a p type layer 14 formed on n type layer 13 and serving as a RESURF layer. Here, each of p type layers 2, 12, 14 is a layer made of SiC and having p type conductivity, and n type layer 13 is a layer made of SiC and having n type conductivity. It should be noted that a plurality of the JFETs each shown in Fig. 1 may be arranged in a direction perpendicular to the plane of sheet of Fig. 1 (direction along the main surface of n type substrate 11). Further, in Fig. 1, p type layer 2 and p type layer 12 are formed, but p type layer 12 may be directly formed on main surface 11A of n type substrate 11.

Main surface 11A of n type substrate 11 has an off angle of not less than 32° relative to the {0001} plane. Further, each of p type layer 2, p type layer 12, n type layer 13, and p type layer 14 is a layer epitaxially grown on/over main surface 11A of n type substrate 11 as described below. Hence, each of the layers has a crystal plane orientation basically the same as that of n type substrate 11. Thus, each of the layers has a main surface (surface parallel to main surface 11A of n type substrate 11) having an off angle of not less than 32° relative to the {0001} plane as with n type substrate 11.

In p type layer 14 and n type layer 13, a source region 15 and a drain region 17 are formed. Each of source region 15 and drain region 17 contains an impurity (n type impurity) of n type conductivity at a concentration higher than that of n type layer 13. Between source region 15 and drain region 17, a gate region 16 is formed. Gate region 16 contains an impurity (p type impurity) of p type conductivity at a concentration higher than that of each of p type layers 12, 14. Namely, source region 15, gate region 16, and drain region 17 are formed to come into n type layer 13 through p type layer 14. Further, each of source region 15, gate region 16, and drain region 17 has a bottom portion located within n type layer 13 and spaced away from the upper surface of p type layer 12 (boundary between p type layer 12 and n type layer 13).

Further, at a side opposite to gate region 16 when viewed from source region 15, a groove portion 31 is formed to extend from the upper surface of p type layer 14 (its main surface opposite to the n type layer 13 side) into n type layer 13 through p type layer 14. In other words, groove portion 31 has a bottom wall spaced away from the interface between p type layer 12 and n type layer 13 and located within n type layer 13. Further, a potential holding region 23 is formed to extend from the bottom wall of groove portion 31 into p type layer 12 through n type layer 13. Potential holding region 23 contains a p type impurity at a concentration higher than those of p type layer 12 and p type layer 14. Potential holding region 23 has a bottom portion spaced away from the upper surface of n type substrate 11 (boundary portion between n type substrate 11 and p type layer 2) (more specifically, spaced away from the boundary portion between p type layer 2 and p type layer 12 and located within p type layer 12).

Further, contact electrodes 19 are formed in contact with the upper surfaces of source region 15, gate region 16, drain region 17, and potential holding region 23, respectively. Each of contact electrodes 19 is made of a material capable of ohmic contact with source region 15, gate region 16, drain region 17, and potential holding region 23, such as NiSi (nickel silicide).

Further, an oxide film 18 is formed between adjacent contact electrodes 19. More specifically, oxide film 18 serving as an insulating film is formed on the upper surface of p type layer 14 and the bottom and side walls of groove portion 31, so as to cover the entire region other than the regions in which contact electrodes 19 are formed. In this way, adjacent contact electrodes 19 are insulated from each other.

Further, a source electrode 25, a gate electrode 26, and a drain electrode 27 are respectively formed in contact with the upper surfaces of contact electrodes 19 provided on source region 15, gate region 16, and drain region 17. Accordingly, source electrode 25, gate electrode 26, and drain electrode 27 are electrically connected to source region 15, gate region 16, and drain region 17 via contact electrodes 19. respectively. Further, source electrode 25 also makes contact with the upper surface of contact electrode 19 provided on potential holding region 23 and is therefore electrically connected to potential holding region 23 via contact electrode 19. In other words, source electrode 25 is formed to extend from the upper surface of contact electrode 19 provided on source region 15 to the upper surface of contact electrode 19 provided on potential holding region 23. Accordingly, contact electrode 19 provided on potential holding region 23 is held at the same potential as that of contact electrode 19 provided on source region 15.

Each of source electrode 25, gate electrode 26, and drain electrode 27 is formed of, for example, a conductor such as aluminum (Al). Source electrode 25, gate electrode 26, and drain electrode 27 extend in a direction in which JFETs 10 are arranged, thereby electrically connecting source regions 15, gate regions 16, and drain regions 17 of the plurality of JFETs 10 to one another via contact electrodes 19. In this way, the plurality of JFETs 10 are connected to each other in parallel by source electrodes 25 connecting source regions 15 to each other, drain electrodes 27 connecting drain regions 17 to each other, and gate electrodes 26 connecting gate regions 16 to each other.

Further, in JFET 10 shown in Fig. 1, an insulating protection film 28 formed of an insulator is formed to cover oxide film 18 and gate electrode 26 and to fill a region between source electrode 25 and drain electrode 27. In insulating protection film 28, openings 33, 34 are respectively formed in a region over source region 15 and potential holding region 23 and a region over drain region 17. In openings 33, 34, source electrode 25 and drain electrode 27 described above are provided. The upper surfaces of source electrode 25 and drain electrode 27 are located above the upper surface of insulating protection film 28 (i.e., source electrode 25 and drain electrode 27 have their upper portions projecting relative to the upper surface of insulating protection film 28). Further, source electrode 25, gate electrode 26, and drain electrode 27 are respectively electrically connected to a source electrode pad, a gate electrode pad, and a drain electrode pad, each of which is not shown in the figures and is adapted to connect source electrode 25, gate electrode 26, and drain electrode 27 to outside. These source electrode pad, gate electrode pad, and drain electrode pad are exposed from insulating protection film 28. In this way, a voltage can be externally applied to source regions 15, gate regions 16, and drain regions 17 of JFETs 10 connected to each other in parallel. In addition, because JFETs 10 are thus connected to each other in parallel, a semiconductor device inclusive of JFETs 10 allows a large amount of current to flow therein.

The following describes operations of JFET 10, assuming that JFET 10 is of normally-on type, for example. Referring to Fig. 1, in n type layer 13, a region sandwiched between drain region 17 and gate region 16, a region sandwiched between the foregoing sandwiched region and p type layer 12, and a region sandwiched between gate region 16 and p type layer 12 are not depleted when gate electrode 26 has a potential of 0 V. Hence, source region 15 and drain region 17 are electrically connected to each other via n type layer 13. Accordingly, when an electric field is applied between source electrode 25 and drain electrode 27, electrons are moved between source region 15 and drain region 17, whereby a current flows between source electrode 25 and drain electrode 27 (ON state).

Meanwhile, when applying a negative voltage to gate electrode 26, depletion develops in a drift region (portions of n type layer 13 and p type layer 14 between gate region 16 and drain region 17) in which electrons are to move, thereby electrically disconnecting source region 15 and drain region 17 from each other. Accordingly, the electrons cannot be moved between source region 15 and drain region 17, with the result that no current flows (OFF state). Here, JFET 10 in the present embodiment is a RESURF type JFET having p type layer 14 (resurf layer) formed on and in contact with n type layer 13. Accordingly, in the OFF state, the depletion layer in the drift region extends in the upward/downward direction (in the thickness direction) from an interface between n type layer 13 and p type layer 14. Accordingly, electric field distribution in the drift region becomes uniform to relax electric field concentration in the vicinity of gate region 16, thereby improving breakdown voltage.

Further, in JFET 10 shown in Fig. 1, electrons flows from source region 15 to drain region 17 in the direction along the main surface of n type substrate 11 as described above (i.e., direction along the crystal plane having an off angle of not less than 32° relative to the {0001} plane). Accordingly, the mobility of electrons can be higher than that in the conventional JFET (i.e., that in the case where the electrons are moved in the direction along the {0001} plane). This leads to reduced on-resistance of JFET 10, as compared with that in the conventional JFET. Further, the direction in which an electric field is applied in the drift layer of JFET 10 according to the present invention is also along the crystal plane having an off angle of not less than 32° relative to the {0001} plane. This leads to increased breakdown voltage as compared with that of the above-described conventional JFET.

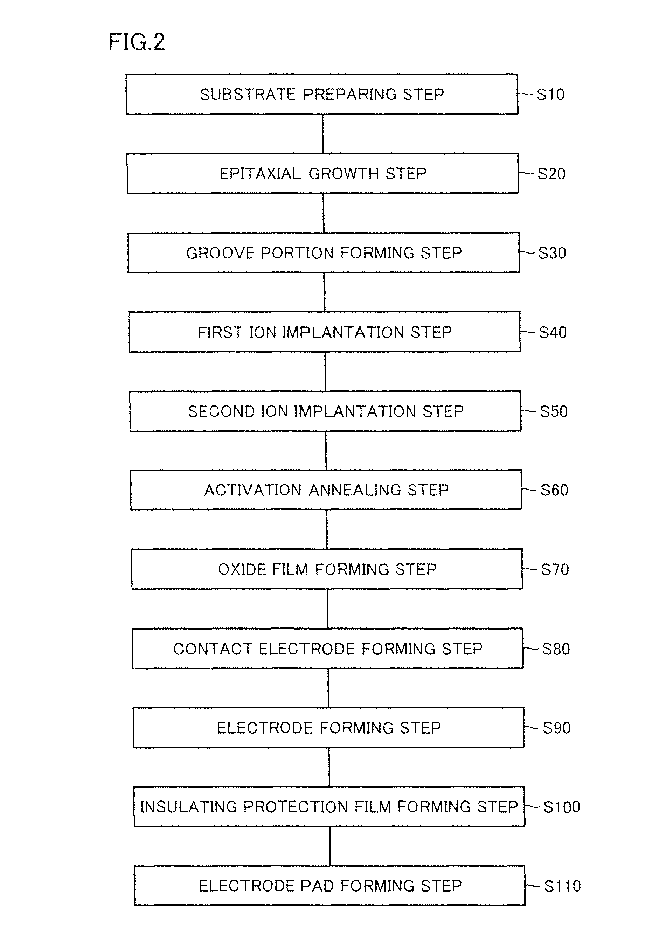

Referring to Fig. 2 to Fig. 10, the following describes a method for manufacturing JFET 10 serving as the silicon carbide semiconductor device in the first embodiment.

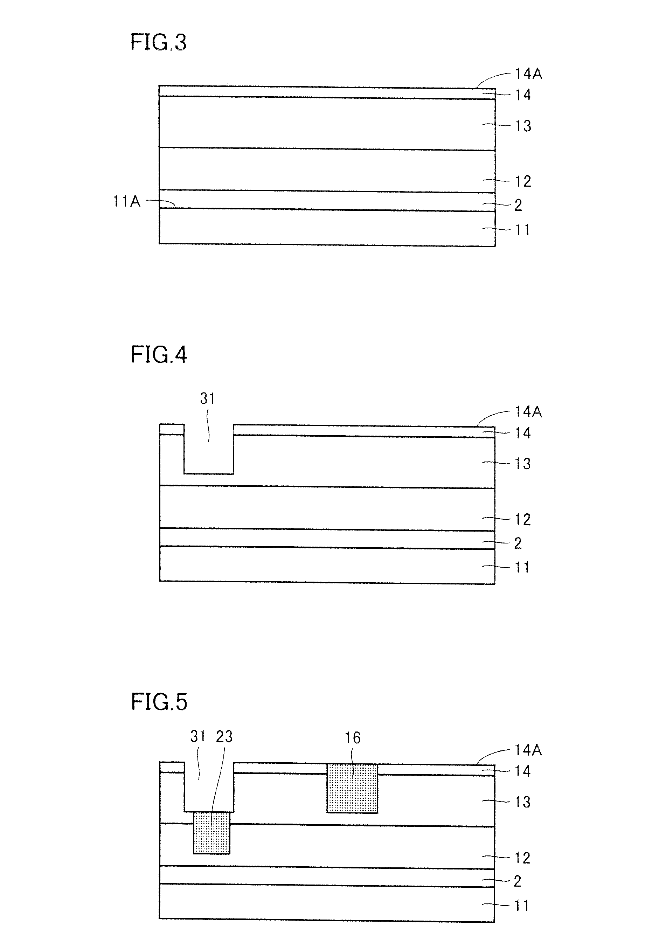

Referring to Fig. 2, in the method for manufacturing JFET 10 in the first embodiment, a substrate preparing step is performed as a step (S10). Specifically, in step (S10), n type substrate 11 made of SiC and containing the high-concentration n type impurity is prepared as shown in Fig. 5. N type substrate 11 has its main surface having an off angle of not less than 32°, more preferably, not less than 38° relative to the {0001} plane. Such an n type substrate 11 can be obtained using an appropriate conventionally known method. For example, n type substrate 11 can be obtained by slicing a SiC ingot, which has one main surface corresponding to the {0001} plane, to exhibit a predetermined crystal plane (along a direction inclined relative to the {0001} plane).

Next, referring to Fig. 2, an epitaxial growth step is performed as a step (S20). In this step (S20), referring to Fig. 3, on one main surface of n type substrate 11 prepared in step (S10), p type layer 2, p type layer 12, n type layer 13, and p type layer 14, each of which is made of SiC, are sequentially formed by means of, for example, vapor phase epitaxy. In the vapor phase epitaxy, for example, silane (SiH₄) gas and propane (C₃H₈) gas are used as material gas, and hydrogen (H₂) gas is employed as carrier gas. Further, examples of a p type impurity source usable for forming the p type layers include diborane (B₂H₆) and trimethylaluminum (TMA). An example of an n type impurity usable for forming the n type layer includes nitrogen (N₂).

Next, referring to Fig. 2, as a step (S30), a groove portion forming step is performed. Specifically, in step (S30), as shown in Fig. 4, groove portion 31 is formed to extend from upper surface 14A of p type layer 14 into n type layer 13 through p type layer 14. Groove portion 31 can be formed by, for example, performing dry etching using for example SF₆ gas after forming, on upper surface 14A of p type layer 14, a mask layer having an opening for a desired location in which groove portion 31 is to be formed.

Next, a first ion implantation step is performed as a step (S40). In this step (S40), the gate region and the potential holding region (base contact region), each of which is a region containing the high-concentration p type impurity, are formed. Specifically, referring to Fig. 5, a resist is first applied onto upper surface 14A of p type layer 14 and the inner wall of groove portion 31, and then exposure and development are performed, thereby forming a resist film having openings for regions corresponding to desired planar shapes of gate region 16 and potential holding region 23. Then, using this resist film as a mask, a p type impurity such as Al (aluminum) or B (boron) is introduced into p type layer 14, n type layer 13, and p type layer 12 by means of ion implantation. Accordingly, gate region 16 and potential holding region 23 are formed.

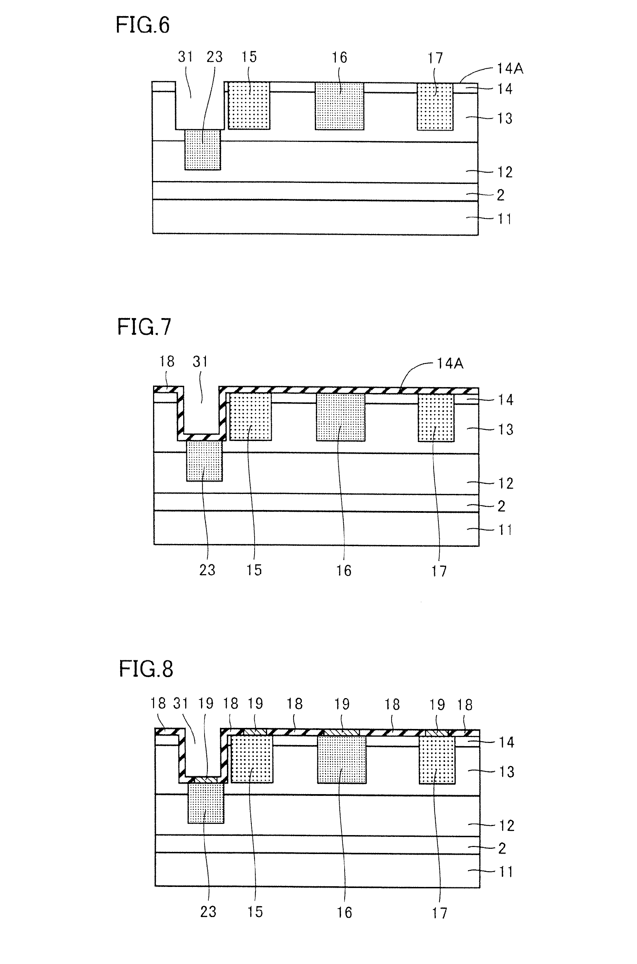

Next, as a step (S50), a second ion implantation step is performed. In this step (S50), source region 15 and drain region 17, each of which is a region containing the high-concentration n type impurity, are formed. Specifically, referring to Fig. 6, a resist film is first formed in the same procedure as that in step (S40). The resist has openings for regions corresponding to desired planar shapes of source region 15 and drain region 17. Then, using the resist film as a mask, the n type impurity such as P (phosphorus) or N (nitrogen) is introduced into each of p type layer 14 and n type layer 13 by means of ion implantation. In this way, source region 15 and drain region 17 are formed.

Next, referring to Fig. 2, an activation annealing step is performed as a step (S60). In this step (S60), the resist film formed in step (S50) is removed, and thereafter p type layer 14, n type layer 13, and p type layer 12 having been through the ion implantation in step (S40) and step (S50) are heated, thereby implementing activation annealing, which is heat treatment for activating the impurities introduced by the ion implantation. The activation annealing can be implemented by, for example, performing heat treatment in an argon gas atmosphere at a temperature of approximately 1700°C for 30 minutes.

Next, an oxide film forming step is performed as a step (S70). In this step (S70), referring to Fig. 7, n type substrate 11 is thermally oxided. N type substrate 11 now includes p type layer 14, n type layer 13, p type layer 12, and p type layer 2, each of which includes the desired ion implantation layer as a result of step (S10) to step (S60). As a result, oxide film 18 made of silicon dioxide (SiO₂) is formed to cover upper surface 14A of p type layer 14 and the inner wall of groove portion 31.

Next, referring to Fig. 2, a contact electrode forming step is performed as a step (S80). In this step (S80), referring to Fig. 8, contact electrodes 19, each of which is made of for example NiSi, are formed in contact with the respective upper surfaces of source region 15, gate region 16, drain region 17, and potential holding region 23. Specifically, a resist film is first formed in the same procedure as that in step (S40). The resist has openings for regions corresponding to desired planar shapes of contact electrodes 19. Then, using the resist film as a mask, portions of oxide film 18 on source region 15, gate region 16, drain region 17, and potential holding region 23 are removed by RIE (Reactive Ion Etching), for example.

Thereafter, for example, Ni (nickel) is deposited, thereby forming a nickel layer on the resist film and exposed portions of source region 15, gate region 16, drain region 17 and potential holding region 23 from oxide film 18. Then, the resist film is removed. In this way, the nickel layer provided on the resist film is removed (lifted off), whereby the nickel layer remains on the exposed portions of source region 15, gate region 16, drain region 17, and potential holding region 23 from oxide film 18. Then, heat treatment is performed to heat them to a predetermined temperature (for example 950°C) in a temperature range of, for example, not less than 900°C to not more than 1000°C, thereby siliciding the nickel layer. In this way, as shown in Fig. 8, contact electrodes 19 are formed each of which is an ohmic electrode made of NiSi capable of ohmic contact with source region 15, gate region 16, drain region 17, and potential holding region 23.

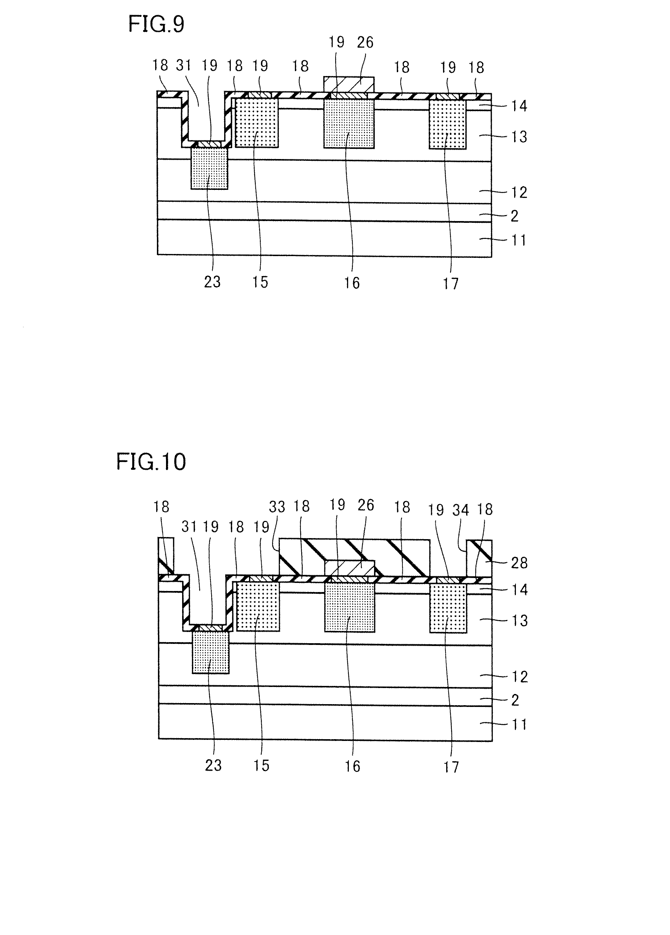

Next, referring to Fig. 2, an electrode forming step is performed as a step (S90). In this step (S90), referring to Fig. 9, gate electrode 26 is formed in contact with the upper surface of contact electrode 19 provided on gate region 16. Gate electrode 26 and drain electrode 27 can be formed by, for example, forming a resist film having openings for desired regions in which source electrode 25, gate electrode 26, and drain electrode 27 are to be formed; depositing Al thereto; and then removing (lifting off) the resist film and Al deposited on the resist film.

Next, referring to Fig. 2, an insulating protection film forming step is performed as a step (S100). In this step (S100), referring to Fig. 10 and Fig. 1, insulating protection film 28, which is made of an insulator such as SiO₂, is formed to cover gate electrode 26, contact electrode 19, and oxide film 18. Specifically, insulating protection film 28, which is constituted by a SiO₂ film, is formed by means of, for example, a CVD method (Chemical Vapor Deposition method), so as to cover gate electrode 26, oxide film 18, and contact electrodes 19 provided on source region 15, drain region 17, and potential holding region 23 (see Fig. 10).

Next, referring to Fig. 4, an electrode pad forming step is formed as a step (S110). Referring to Fig. 1, formed in this step (S110) are: source electrode 25 making contact with the upper surfaces of contact electrodes 19 provided on source region 15 and potential holding region 23; drain electrode 27 making contact with the upper surface of contact electrode 19 provided on drain region 17; the source electrode pad electrically connected to source electrode 25; the gate electrode pad electrically connected to gate electrode 26; and the drain electrode pad electrically connected to drain electrode 27. Specifically, first, as shown in Fig. 10, openings 33, 34 are formed using a photolithography method at the regions of insulating protection film 28 over source region 15, drain region 17, and potential holding region 23. An exemplary method of forming openings 33, 34 is to form, on the main surface of insulating protection film 28, a resist film having openings corresponding to the planar shapes of opening 33, 34, and then remove portions of insulating protection film 28 by means of etching using the resist film as a mask. In this way, openings 33, 34 are formed in insulating protection film 28 as shown in Fig. 10. It should be noted that when the resist film is removed by means of an appropriate conventionally known method after forming openings 33, 34 as described above, the structure shown in Fig. 10 can be obtained.

Then, for example, a resist film is formed which has openings for desired regions in which source electrode 25 and drain electrode 27 are to be formed (regions where openings 33, 34 described above are formed). Then, Al is deposited thereto, and the resist film and Al deposited on the resist film are removed (lifted off), thereby forming source electrode 25 and drain electrode 27. Further, the source electrode pad connected to source electrode 25, the drain electrode pad connected to drain electrode 27, and the gate electrode pad connected to gate electrode 26 may be simultaneously formed during the formation of source electrode 25 and drain electrode 27, for example. Namely, the resist film is provided with an opening for a region which partially overlaps with gate electrode 26 and in which the gate electrode pad is to be formed. Then, Al is also deposited into the opening during the deposition of Al that is to be formed into source electrode 25 and drain electrode 27. Thereafter, lift-off is performed to form the gate electrode pad. Further, each of the source electrode pad and the drain electrode pad may be formed in a manner similar to that for the gate electrode pad.

It should be noted that the foregoing resist film used to form openings 33, 34 may be used for the resist film used to form source electrode 25 and drain electrode 27. In other words, without removing the resist film after forming openings 33, 34 by means of etching using the resist film as a mask, the conductor film such as Al for forming the electrodes may be formed and then source electrode 25 and drain electrode 27 may be formed within openings 33, 34 by means of lift-off.

Here, a plurality of the structures of JFETs 10 each described above may be formed side by side in steps (S20) to (S80) on n type substrate 11 prepared in step (S10). Then, referring to Fig. 1, in step (S90) to step (S 110), source electrodes 25, gate electrodes 26, and drain electrodes 27 are formed to connect source regions 15, gate regions 16, and drain regions 17 of the plurality of JFETs 10 to one another via contact electrodes 19. In this way, the plurality of JFETs 10 are connected to each other in parallel by source electrodes 25 connecting source regions 15 to each other, drain electrodes 27 connecting drain regions 17 to each other, and gate electrodes 26 connecting gate regions 16 to each other. With the above-described steps, JFET(s) 10 in the present embodiment are completed.

### (Second Embodiment)

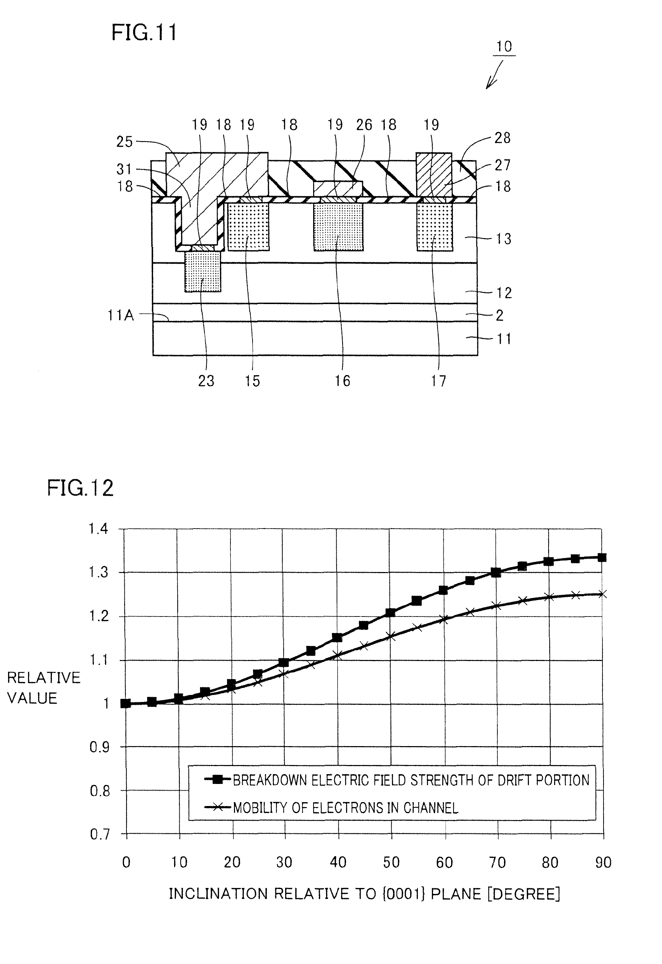

Referring to Fig. 11, a second embodiment of the silicon carbide semiconductor device according to the present invention will be described below. The silicon carbide semiconductor device shown in Fig. 11 is a JFET as with the silicon carbide semiconductor device shown in Fig. 1, and has basically the same structure as that of JFET 10 shown in Fig. 1 but is different from JFET 10 shown in Fig. 1 in that no p type layer 14 shown in Fig. 1 is formed on n type layer 13. Namely, in JFET 10 shown in Fig. 11, source region 15, gate region 16, and drain region 17 are formed in n type layer 13, and oxide film 18 are formed on the upper surface of n type layer 13 (and the inner wall of groove portion 31).

JFET 10 shown in Fig. 11 does not attain the effect provided by p type layer 14 serving as a resurf layer and formed in JFET 10 shown in Fig. 1. However, because n type substrate 11 has a main surface having an off angle of not less than 32° relative to the {0001} plane, the mobility of electrons in the channel layer and the breakdown voltage thereof can be higher than those of the conventional JFET as with JFET 10 shown in Fig. 1.

Further, a method for manufacturing JFET 10 shown in Fig. 11 is basically the same as the method for manufacturing JFET 10 shown in Fig. 1. However, in step (S20), i.e., the epitaxial growth step shown in Fig. 2, only p type layer 2, p type layer 12, and n type layer 13 are formed on/over the main surface of n type substrate 11 (namely, p type layer 14 serving as a resurf layer is not formed on n type layer 13). The method for manufacturing JFET 10 shown in Fig. 11 is different from the method for manufacturing JFET 10 shown in Fig. 1 only in this point. The other manufacturing processes are the same as those for JFET 10 shown in Fig. 1.

The following describes characteristic configurations of the present invention although some of them have been already described in the above-described embodiments. A JFET 10, which is a silicon carbide semiconductor device according to the present invention, includes: an n type substrate 11 serving as a substrate; a first semiconductor layer (p type layers 2, 12); a second semiconductor layer (n type layer 13); a source region 15; a drain region 17; and a gate region 16. N type substrate 11 has a main surface 11 A having an off angle of not less than 32° relative to a {0001} plane and is made of silicon carbide (SiC). The first semiconductor layer (p type layers 2, 12) is formed on main surface 11 A of n type substrate 11, and has a first conductivity type (p type). The second semiconductor layer (n type layer 13) is formed on the first semiconductor layer (p type layers 2, 12), and has a second conductivity type (n type). Source region 15 and drain region 17 are formed in the second semiconductor layer (n type layer 13) with a space interposed therebetween, and have the second conductivity type (n type). Gate region 16 is formed in the second semiconductor layer (n type layer 13) at a region between source region 15 and drain region 17, and has the first conductivity type (p type).

In this way, the silicon carbide semiconductor device according to the present invention is configured as a lateral type junction field effect transistor and has a drift layer (region between gate region 16 and drain region 17) in which an electric field is applied in a direction parallel to main surface 11 A of n type substrate 11 (i.e., direction along the surface having an off angle of not less than 32° relative to the {0001} plane). Accordingly, the breakdown voltage can be increased by 10% or greater as compared with that in the conventional silicon carbide semiconductor device in which the electric field is applied in the direction parallel to the {0001} plane. Further, according to the present invention, a current in the channel layer (n type layer 13) of the silicon carbide semiconductor device flows in the direction parallel to main surface 11A of n type substrate 11, which has an off angle of not less than 32° relative to the {0001} plane. Accordingly, the mobility of electrons can be increased in the channel layer (n type layer 13) as compared with that in the conventional silicon carbide semiconductor device (that in the case where a current in the channel layer flows in the direction parallel to the {0001} plane). Accordingly, on-resistance can be reduced as compared with that in the conventional silicon carbide semiconductor device.

In JFET 10, at least between gate region 16 and drain region 17, the second semiconductor layer (n type layer 13) may have a surface layer serving as a third semiconductor layer (p type layer 14) of the first conductivity type (p type). In this case, a so-called RESURF structure is formed between gate region 16 and drain region 17 by n type layer 13 and p type layer 14. In other words, while the silicon carbide semiconductor device is off, a depletion layer extends between gate region 16 and drain region 17 from a boundary portion between n type layer 13 and p type layer 14 in the upward/downward direction (direction intersecting with main surface 11 A of n type substrate 11), thereby attaining uniform electric field distribution in the region (so called "drift region") between gate region 16 and drain region 17. Accordingly, electric field concentration is relaxed in the vicinity of gate electrode 26, thereby restraining dielectric breakdown, which may be otherwise caused by the electric field concentration. This leads to improved breakdown voltage property of JFET 10.

In JFET 10, the first semiconductor layer (p type layers 2, 12) may include a lower semiconductor layer (p type layer 2) and an upper semiconductor layer (p type layer 12). The lower semiconductor layer (p type layer 2) is formed on main surface 11 A of n type substrate 11. and has the first conductivity type (p type). The upper semiconductor layer (p type layer 12) is formed on p type layer 2, has an impurity concentration lower than that of p type layer 2, and has the first conductivity type (p type). In this case, the upper semiconductor layer can be utilized as a so-called "breakdown voltage holding layer", and the lower semiconductor layer can be utilized as a so-called "electric field relaxing layer".

In JFET 10, main surface 11 A of n type substrate 11 may have an off angle of not less than 38° relative to the {0001} plane. In this case, in the drift layer of JFET 10, the direction in which the electric field is applied is a direction allowing for higher mobility of electrons. Accordingly, JFET 10 obtained achieves a lower on-resistance securely than that in the conventional JFET (on-resistance smaller than that in the conventional JFET by not less than 10%).

In JFET 10, main surface 11 A of n type substrate 11 may have an off angle of ±5° or smaller relative to a {03-38} plane. Here, the phrase "having an off angle of ±5° or smaller relative to the {03-38}" is intended to encompass, for example, a case where the crystal plane constituting the main surface 11A is the {03-38} plane, and a case where the crystal plane constituting main surface 11 A has an off angle of not less than -5° and not more than 5° relative to the {03-38} plane in a specific crystal orientation (for example, <1-100> direction). It should be noted that the "off angle relative to the {03-38} plane in the <1-100> direction" refers to an angle formed by an orthogonal projection of a normal line of the above-described end surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction. In this case, main surface 11 A of n type substrate 11 corresponds to the {03-38} plane, which is a natural plane of silicon carbide, or has an off angle of ±5° or smaller relative to the {03-38} plane (i.e., crystal plane substantially regarded as the {03-38} plane). Accordingly, as described above, the mobility of electrons in the channel layer can be increased in the direction along main surface 11A of n type substrate 11. In addition, when an insulating film such as oxide film 18 is formed on a surface of an epitaxial layer formed on main surface 11 A of n type substrate 11, an interface state between oxide film 18 and the epitaxial layer becomes excellent.

In JFET 10, main surface 11 A of n type substrate 11 may have an off angle of ±5° or smaller relative to a {11-20} plane. In this case, main surface 11A of n type substrate 11 corresponds to the {11-20} plane, which is a natural plane of silicon carbide, or has an off angle of ±5° or smaller relative to the {11-20} plane (i.e., crystal plane substantially regarded as the {11-20} plane). Accordingly, as described above, the mobility of electrons in the channel layer can be increased in the direction along main surface 11 A of n type substrate 11. In addition, when an insulating film such as oxide film 18 is formed on a surface of an epitaxial layer formed on main surface 11A of n type substrate 11, an interface state between oxide film 18 and the epitaxial layer becomes excellent.

In JFET 10, main surface 11 A of n type substrate 11 may have an off angle of ±5° or smaller relative to the {1-100} plane. In this case, main surface 11A of n type substrate 11 corresponds to the {1-100} plane, which is a natural plane of silicon carbide, or has an off angle of ±5° or smaller relative to the {1-100} plane (i.e., crystal plane substantially regarded as the {1-100} plane). Accordingly, as described above, the mobility of electrons in the channel layer can be increased in the direction along main surface 11A of n type substrate 11. In addition, when an insulating film such as oxide film 18 is formed on a surface of an epitaxial layer formed on main surface 11A of n type substrate 11, an interface state between oxide film 18 and the epitaxial layer becomes excellent.

### (Example 1)

In order to confirm the effects of the present invention, the following experiment was conducted.

### (Preparation of Samples)

Using the method for manufacturing the semiconductor device as shown in Fig. 2, four types of samples were prepared as samples for the test. The samples were JFETs configured as shown in Fig. 1 and have substrates having main surfaces with different plane orientations. First, as step (S10) shown in Fig. 2, four types of n type substrates each made of 4H-SiC were prepared. Specifically, in order to fabricate samples of examples of the present invention, the following three types of substrates were prepared: an n type substrate having a main surface corresponding to the (03-38) plane; an n type substrate having a main surface corresponding to the (11-20) plane; and an n type substrate having a main surface corresponding to the (1-100) plane. In order to fabricate a sample of a comparative example, there was prepared an n type substrate made of 4H-SiC and having a main surface corresponding to the (0001) plane.

It should be noted that the (03-38) plane is a plane inclined by 54.7° relative to the {0001} plane in the <01-10> direction. Further, the (11-20) plane is a plane inclined by 90° relative to the {0001} plane in the <11-20> direction. Furthermore, the (1-100) plane is a plane inclined by 90° relative to the {0001} plane in the <1-100> direction. Each of the above-described planes is a so-called "natural plane". On the main surfaces of such substrates, epitaxial layers of SiC were formed. These epitaxial layers have their upper surfaces corresponding to the same crystal planes (natural planes) of the main surfaces of the substrates. When forming an insulating film such as an oxide film on each of the main surfaces corresponding to the natural planes, an interface between the insulating film and each epitaxial layer made of silicon carbide can be smooth. Accordingly, the insulating film obtained is high in reliability.

Using the above-described four types of substrates, the JFETs each having the structure shown in Fig. 1 were fabricated as the samples of examples 1-3 and the comparative example, in accordance with the manufacturing method shown in Fig. 2 to Fig. 10. First, step (S20) shown in Fig. 2 was performed. Specifically, a SiC epitaxial layer was formed on the main surface of each of the substrates as p type layer 2 serving as an electric field relaxing layer, so as to have a p type impurity density of 5.0 × 10¹⁷ cm⁻³. P type layer 2 had a thickness of 0.5 µm. As the p type impurity, aluminum (Al) was employed. Next, on p type layer 2, a SiC epitaxial layer was formed as p type layer 12 serving as a breakdown voltage holding layer, so as to have a p type impurity density of 1.0 × 10¹⁶ cm⁻³. P type layer 12 had a thickness of 10 µm. As the p type impurity, aluminum (Al) was employed.

Next, on p type layer 12, an SiC epitaxial layer was formed as n type layer 13 serving as a channel layer, so as to have an n type impurity density of 2.0 × 10¹⁷ cm⁻³. N type layer 13 had a thickness of 0.4 µm. As the n type impurity, nitrogen (N) was employed. Next, on n type layer 13, a SiC epitaxial layer was formed as p type layer 14 serving as a resurf layer, so as to have a p type impurity density of 2.0 × 10¹⁷ cm⁻³. P type layer 14 had a thickness of 0.3 µm. As the p type impurity, aluminum (Al) was employed.

Next, step (S30) shown in Fig. 2 was performed. Specifically, groove portion 31 was fabricated by dry etching to have a depth of 0.4 µm. Next, step (S40) shown in Fig. 2 was performed. Specifically, as a p type impurity, Al ions were implanted into the epitaxial layers, thereby forming gate region 16 and potential holding region 23 (base contact region) of p type. Each of gate region 16 and potential holding region 23 had a depth of 0.5 µm. Next, step (S50) shown in Fig. 2 was performed. Specifically, as the n type impurity, ions of phosphorus (P) were implanted into the epitaxial layers, thereby forming source region 15 and drain region 17 of n type. Each of source region 15 and drain region 17 had a depth of 0.5 µm.

Next, step (S60) shown in Fig. 2 was performed. Specifically, heat treatment (activation annealing process) was performed onto each of the substrates each having the epitaxial layers in which source region 15, gate region 16, drain region 17, and potential holding region 23 were formed. The heat treatment was conducted at a heating temperature of 1700°C in an argon (Ar) atmosphere for a retention time of 30 minutes.

Next, step (S70) shown in Fig. 2 was performed. Specifically, the substrate was thermally treated in an oxygen atmosphere at a heating temperature of 1300°C for a retention time of 60 minutes, thereby forming oxide film 18 (field oxide film) shown in Fig. 7. Oxide film 18 had a thickness of 0.1 µm.

Next, step (S80) shown in Fig. 2 was performed. Specifically, using the lift-off method, nickel (Ni) was formed in contact with the upper surfaces of source region 15, gate region 16, drain region 17, and potential holding region 23. Thereafter, heat treatment was performed in an argon atmosphere at a heating temperature of 950°C for a retention time of 2 minutes, thereby forming contact electrodes 19 making ohmic contact with source region 15, gate region 16, drain region 17, and potential holding region 23 respectively.

Next, step (S90) shown in Fig. 2 was performed. Specifically, by depositing Al, gate electrode 26 was formed. Next, step (S100) shown in Fig. 2 was performed. Specifically, a plasma CVD method was employed to form insulating protection film 28 made of SiO₂.

Next, step (S110) shown in Fig. 2 was performed. Specifically, openings 33, 34 were formed in predetermined locations of insulating protection film 28, and source electrode 25, drain electrode 27, the source electrode pad, the gate electrode pad, and the drain electrode pad each made of Al were formed.

### (Experiment Method)

The breakdown voltage and on-resistance of each of the fabricated samples of examples 1-3 and the comparative example were measured. The measurement on the breakdown voltage and the on-resistance was performed with each of the samples being set in a prober and with probe needles, which are respectively in contact with the source electrode pad, the gate electrode pad, and the drain electrode pad, being connected to a semiconductor parameter analyzer.

### (Results)

As to On-Resistance

The on-resistance of the sample of the comparative example was regarded as a reference. The sample of example 1 had an on-resistance 0.85 times as large as that of the comparative example. The sample of example 2 had an on-resistance 0.80 times as large as that of the comparative example. The sample of example 3 had an on-resistance 0.80 times as large as that of the comparative example.

As to Breakdown Voltage

The breakdown voltage of the sample of the comparative example is regarded as a reference. The sample of example 1 had a breakdown voltage 1.23 times as large as that of the comparative example. The sample of example 2 had a breakdown voltage 1.33 times as large as that of the comparative example. The sample of example 3 had a breakdown voltage 1.33 times as large as that of the comparative example.

Thus, it can be understood that as compared with the comparative example, each of the samples of the examples of the present invention achieved reduced on-resistance and improved breakdown voltage.

### (Example 2)

From measurement data of breakdown electric field strength and mobility of electrons in the <0001> direction and the direction perpendicular thereto in 4H-SiC, the present inventor calculated breakdown electric field strength (breakdown voltage) in the drift region (drift portion) and the mobility of electrons in the channel when differing the angle of inclination (off angle) of the main surface of the substrate constituting the JFET shown in Fig. 1 relative to the {0001} plane. Results thereof are shown in Fig. 12.

Referring to Fig. 12, the horizontal axis of a graph shown in Fig. 12 represents an inclination (off angle) of the main surface of the substrate constituting the JFET, relative to the {0001} plane. The inclination is handled based on "°" as unit. Meanwhile, the vertical axis thereof represents relative values of the breakdown electric field strength (breakdown voltage) in the drift portion of the JFET and the mobility of electrons in the channel layer. It should be noted that the relative values of the breakdown voltage and the mobility of electrons are shown assuming that values thereof when the main surface of the substrate has an off angle of 0° relative to the {0001} plane are regarded as respective references. As apparent from Fig. 12, when the main surface of the substrate has an off angle of not less than 32° relative to the {0001} plane, the breakdown voltage is 1.1 times or greater as large as the reference value (breakdown voltage when the main surface of the substrate corresponds to the {0001} plane). Further, when the off angle is equal to or greater than 38°, the mobility of electrons in the channel is 1.1 times or greater as large as the reference value (mobility of electrons when the main surface of the substrate corresponds to the {0001} plane).

The embodiments and examples disclosed herein are illustrative and non-restrictive in any respect. The scope of the present invention is defined by the terms of the claims, rather than the embodiments and examples described above, and is intended to include any modifications within the scope and meaning equivalent to the terms of the claims.

### INDUSTRIAL APPLICABILITY

The present invention is particularly advantageously applicable to a lateral type junction field effect transistor employing a substrate made of silicon carbide.

### REFERENCE SIGNS LIST

2, 12, 14: p type layer; 10: JFET; 11: n type substrate; 11A: main surface; 13: n type layer; 14A: upper surface; 15: source region; 16: gate region; 17: drain region; 18: oxide film; 19: contact electrode; 23: potential holding region; 25: source electrode; 26: gate electrode; 27: drain electrode; 28: insulating protection film; 31: groove portion; 33, 34: opening.

## Claims

1. A silicon carbide semiconductor device comprising:
a substrate (11) made of silicon carbide and having a main surface (11A) having an off angle of not less than 32° relative to a {0001} plane;
a first semiconductor layer (2, 12) having a first conductivity type and formed on the main surface (11A) of said substrate (11);
a second semiconductor layer (13) having a second conductivity type and formed on said first semiconductor layer (2, 12);
a source region (15) and a drain region (17) each having the second conductivity type and formed in said second semiconductor layer (13) with a space interposed therebetween; and
a gate region (16) having the first conductivity type and formed in said second semiconductor layer (13) at a region between said source region (15) and said drain region (17).

2. The silicon carbide semiconductor device according to claim 1, wherein at least between said gate region (16) and said drain region (17), said second semiconductor layer (13) has a surface layer serving as a third semiconductor layer (14) of the first conductivity type.

3. The silicon carbide semiconductor device according to claim 1, wherein:
said first semiconductor layer (2, 12) includes
a lower semiconductor layer (2) having the first conductivity type and formed on the main surface (11A) of said substrate (11), and
an upper semiconductor layer (12) having the first conductivity type, formed on said lower semiconductor layer (2), and having an impurity concentration lower than that of said lower semiconductor layer (2).

4. The silicon carbide semiconductor device according to claim 1, wherein said main surface (11A) of said substrate (11) has an off angle of not less than 38° relative to the {0001} plane.

5. The silicon carbide semiconductor device according to claim 1, wherein said main surface (11A) of said substrate (11) has an off angle of ±5° or smaller relative to a {03-38} plane.

6. The silicon carbide semiconductor device according to claim 1, wherein said main surface (11A) of said substrate (11) has an off angle of ±5° or smaller relative to a {11-20} plane.

7. The silicon carbide semiconductor device according to claim 1, wherein said main surface (11A) of said substrate (11) has an off angle of ±5° or smaller relative to a {1-100} plane.
